Europäisches Patentamt

European Patent Office

Office européen des brevets

(19)

(11) Veröffentlichungsnummer : **0 065 762**
**B1**

(12) **EUROPÄISCHE PATENTSCHRIFT**

(45) Veröffentlichungstag der Patentschrift :
18.09.85

(21) Anmeldenummer : 82104418.7

(22) Anmeldetag : 19.05.82

(51) Int. Cl.⁴ : **G 01 R 33/04**

(54) **Verfahren und Schaltungsanordnung zur Messung eines Magnetfeldes, insbesondere des Erdmagnetfeldes.**

(30) Priorität : 27.05.81 DE 3121234

(43) Veröffentlichungstag der Anmeldung :
01.12.82 Patentblatt 82/48

(45) Bekanntmachung des Hinweises auf die Patenterteilung : 18.09.85 Patentblatt 85/38

(84) Benannte Vertragsstaaten :
AT BE CH DE FR GB IT LI NL

(56) Entgegenhaltungen :
DE-A- 2 949 815
DE-B- 1 942 916
MESSEN + PRÜFEN/AUTOMATIK, Band 8, Heft 12,
Dezember 1972, Bad Wörishofen, G. TRENKLER
"Verfahren zur elektrischen Messung magnetischer
Felder", Seiten 793 bis 797

(73) Patentinhaber : Siemens Aktiengesellschaft
Berlin und München Wittelsbacherplatz 2
D-8000 München 2 (DE)

(72) Erfinder : Kratzer, Wolfgang, Dipl.-Ing.
Karwendelstrasse 25
D-8000 München 70 (DE)
Erfinder : Thilo, Peer, Dr.-Ing.
Buchhierlstrasse 19
D-8000 München 71 (DE)

## Beschreibung

Die Erfindung bezieht sich auf ein Verfahren zur Messung eines Magnetfeldes, insbesondere des Erdmagnetfeldes, mittels einer Magnetsonde in Form einer Spule mit Eisenkern, wobei an die Spule ein veränderlicher Erregerstrom von einer derartigen Größe angelegt wird, daß der Eisenkern jeweils den positiven und den negativen Sättigungswert erreicht, und wobei durch Messung der induzierten Spannung an der Spule die Änderung des Induktivitätsverlaufes gegenüber dem Verlauf des Erregerstroms ermittelt und daraus die Stärke des äußeren Magnetfeldes in Richtung der Sondenachse gewonnen wird. Außerdem bezieht sich die Erfindung auf eine Schaltungsanordnung zur Durchführung dieses Verfahrens.

Magnetsonden sind für die genaue Bestimmung des relativ schwachen Erdmagnetfeldes besonders gut geeignet. Bei einem Verfahren zur Feldbestimmung mittels einer Magnetsonde (DE-A-29 49 815, veröffentlicht am 19.06.1981) wird durch die Wicklung der Sonde ein Wechselstrom geführt, der so stark ist, daß das Eisen abwechselnd den positiven und den negativen Sättigungswert erreicht. In einer Sekundärwicklung wird dann eine Spannung induziert, deren positive und negative Halbwellen gleich groß sind, so lange kein äußeres Magnetfeld einwirkt. Überlagert sich jedoch dem inneren Magnetfeld der Sonde das äußere Erdmagnetfeld, so wird je nach dessen Richtung und Stärke die Sättigung früher oder später eintreten und damit die induzierte Sekundärspannung unsymmetrisch werden. Die unterschiedliche Amplitude beider Halbwellen ist ein Maß für die zu messende äußere Feldstärke.

Das Verfahren beruht auf der Nichtlinearität des Eisens. Deswegen zeigt die induzierte Ausgangsspannung eine signifikant andere Kurvenform als der Eingangsstrom. Insbesondere wird eine große Zahl von aussteuerungsabhängigen Oberwellen erzeugt, die sich zu unterschiedlich großen Spitzenspannungen überlagern und so den genauen Vergleich beider Halbwellenamplituden beeinträchtigen. Um diesen Effekt klein zu halten, sind ausgeklügelte, aufwendige Filter und Verstärker erforderlich. Ein weiteres Problem der bekannten Verfahren beruht darauf, daß das erzeugte Signal eine feldstärkeabhängige Spannung ist, welche im allgemeinen zur weiteren Verarbeitung mit einer zusätzlichen Einrichtung erst digitalisiert werden muß.

Vergleichbare Nachteile treten auch bei einer Schaltungsanordnung zur Messung schwacher Magnetfelder gemäß DE-B-19 42 916 auf. Dort wird vorgeschlagen, eine Sonde mit zwei gegensinnig gewickelten Erregerwicklungen mit einem pulsierenden Erregerstrom derart zu speisen, daß der Ringkern im Bereich der Ausgangswicklung nicht vollständig gesättigt wird. Die durch ein äußeres Feld bewirkte Veränderung der Amplitude des von einer Ausgangswicklung abnehmbaren Signals soll dabei zur Messung des äußeren Feldes dienen. Die Messung der Amplituden und die Ermittlung der Feldstärke bzw. der Richtung des Magnetfeldes dürfte dabei einen erheblichen schaltungstechnischen Aufwand erfordern.

Aufgabe der Erfindung ist es, ein Verfahren zur Feldmessung der eingangs erwähnten Art anzugeben, welches eine hohe Meßgenauigkeit bei geringem Geräteaufwand gewährleistet, insbesondere auch einfach zu handhaben ist und möglichst keine aufwendigen Abgleicharbeiten erfordert. Außerdem soll eine Schaltungsanordnung zur Durchführung des Verfahrens geschaffen werden.

Bei dem erfindungsgemäßen Verfahren wird die erstgenannte Aufgabe dadurch gelöst, daß an die Spule ein schrittweise sprungartig von einem negativen Maximalwert bis zu einem positiven Maximalwert ansteigender Erregerstrom angelegt und die an der Spule dadurch induzierten, entsprechend der momentanen Spuleninduktivität mit unterschiedlicher Zeitkonstante abklingenden Spannungsimpulse gemessen werden, daß aus allen Spannungsimpulsen, deren Zeitkonstante einen vorgegebenen Wert überschreitet, Zählimpulse gebildet und die jeweilige Anzahl der Zählimpulse bei jeweils negativem und bei positivem Erregerstrom miteinander verglichen sowie aus dem Differenzbetrag die Stärke des äußeren Magnetfeldes ermittelt wird. Eine vorteilhafte Schaltungsanordnung zur Durchführung des Verfahrens ist mit verschiedenen Ausgestaltungen in den Ansprüchen 6 bis 15 angegeben.

Das erfindungsgemäße Verfahren arbeitet also mit einem Erregerstrom, der von einem negativen Maximalwert bis zu einem positiven Maximalwert ansteigt und die Magnetsonde den gesamten Bereich von der negativen Sättigung bis zur positiven Sättigung durchlaufen läßt. Da der Erregerstrom aber sich nicht nur kontinuierlich, sondern in vielen kleinen Sprüngen verändert, werden auf der Sekundärseite der Sonde entsprechend kleine Spannungsimpulse erzeugt, die mit unterschiedlicher Zeitkonstante abfallen. Diese Zeitkonstante ist ein Maß für die Spuleninduktivität und hat ihren größten Wert beim Induktivitätsmaximum, welches bei einer Spule ohne Fremdfeld beim Nullwert des Erregerstroms liegt.

Durch das äußere Magnetfeld an der Spule wird dieses Induktivitätsmaximum gegenüber dem Nullpunkt der Erregerspannung verschoben, und entsprechend verschiebt sich auch der Wert der Zeitkonstanten bei den einzelnen Sekundärspannungsimpulsen. Es treten also auf einer Seite des Nullpunkts der Erregerspannung mehr Spannungsimpulse mit großer Zeitkonstante auf als auf der anderen Seite. Damit reduziert sich die Auswertung beim erfindungsgemäßen Verfahren auf eine Impulsmessung mit einem digitalen Zähler. Diese Zählung und Differenzbildung ergibt unmittelbar einen Wert für die äußere Feldstärke ; ein zusätzlicher Analog-Digital-Umsetzer ist nicht nötig. Ein weiterer wesentlicher Vorteil dieses Verfahrens liegt auch darin, daß der jeweilige Arbeitspunkt von vornherein auf der Induktivitätskennlinie liegt, wodurch sondenspezifische Abgleichmaßnahmen entfallen. Damit können auch mehrere Sonden mit ein und derselben Auswerteschaltung gemessen werden, die beispielsweise über einen Multiplexer nacheinander angeschaltet werden.

Der Erregerstrom kann in einer vorteilhaften Ausführungsform der Erfindung durch Überlagerung eines linear ansteigenden Stroms mit einem rechteckförmigen Wechselstrom gebildet werden. Hierzu kann eine Gleichstromquelle mit nachgeschaltetem Integrator verwendet werden, dessen linear ansteigendem Ausgangsstrom ein von einem Taktgenerator erzeugter Wechselstrom überlagert ist.

In einer anderen vorteilhaften Ausführungsform wird der Erregerstrom durch eine treppenförmig ansteigende Spannung erzeugt. Hierzu kann beispielsweise ein Digital-Analog-Wandler verwendet werden, an dessen Eingang ein vom Taktgeber beaufschlagter Zähler geschaltet ist.

Die gemessenen Spannungsimpulse werden zur Auswertung zweckmäßigerweise in Rechteckimpulse mit einer der jeweiligen Zeitkonstante proportionalen Impulsbreite umgeformt und jeweils mit einem gegenüber den ansteigenden Flanken des Erregerstroms um eine vorgegebene Zeit verzögerten Zählimpuls verglichen, wobei nur bei gleichzeitigem Vorhandensein beider Impulse der jeweilige Zählimpuls weitergeschaltet wird. Damit werden alle Spannungsimpulse eliminiert, deren Zeitkonstante unterhalb des vorgegebenen Wertes liegt. Dem Vergleich der beiden Impulse über ein Koinzidenzglied ist zweckmäßigerweise eine differenzbildende Impulszähleinrichtung nachgeschaltet, welche entsprechend der Polarität des Erregerstroms umschaltbar ist. Diese Zähleinrichtung kann zwei Zähler enthalten, von denen der eine die Impulse bei negativer Erregerspannung und der andere die Impulse bei positiver Erregerspannung zählt. In einem nachgeschalteten Substrahierer kann dann die Differenz gebildet werden. Statt zweier Zähler kann auch ein einziger Zähler verwendet werden, der bei einer Polarität der Erregerspannung vorwärts und bei der anderen Polarität rückwärts zählt.

Bekanntlich kann man mit zwei zueinander senkrecht angeordneten Sonden einen elektronischen Kompaß bilden, der die Richtung gegenüber den Erdfeldlinien bestimmt. Hierfür ist das erfindungsgemäße Verfahren besonders vorteilhaft anzuwenden, da die Auswerteschaltung abwechselnd an beide Sonden angeschaltet werden kann, so daß sie nur ein einziges Mal vorhanden sein muß. Wie bereits oben erwähnt, erfordert das erfindungsgemäße Verfahren keinen sondenspezifischen Abgleich. Jede Sonde liefert über die Auswerteeinrichtung und die Differenz bildende Zähleinrichtung einen digitalen Meßwert, der einer Winkelfunktion entspricht. Über einen Winkelfunktionsumsetzer kann daraus unmittelbar der Winkel ermittelt werden, den der elektronische Kompaß gegenüber den Erdfeldlinien einnimmt.

Die . Erfindung wird nachfolgend an Ausführungsbeispielen anhand der Zeichnung näher erläutert. Es zeigt

Figur 1 eine Prinzipschaltung zur Durchführung des erfindungsgemäßen Meßverfahrens,

Figur 2 ein Diagramm mit dem Verlauf der Spuleninduktivität und der Sekundärspannung in einer Schaltung nach Fig. 1 ohne äußeres Magnetfeld,

Figur 3 den Verlauf von Spuleninduktivität und Sekundärspannung mit äußerem Magnetfeld,

Figur 4 eine Schaltungsanordnung zur Durchführung des erfindungsgemäßen Verfahrens,

Figur 5 ein Zeitdiagramm für die Strom- und Spannungsverläufe bei der Schaltung nach Fig. 4,

Figur 6 eine abgewandelte Ausführungsform der Erregerstromeinspeisung in der Schaltung nach Fig. 4,

Figur 7 ein Diagramm zum Vergleich der bei verschiedenen Erregerströmen erzeugten Spannungsimpulse,

Figur 8 eine Prinzipschaltung für einen elektronischen Kompaß, der nach dem erfindungsgemäßen Prinzip arbeitet,

Figur 9 eine Variante der Spannungsmeßeinrichtung in der Schaltungsanordnung nach Fig. 4.

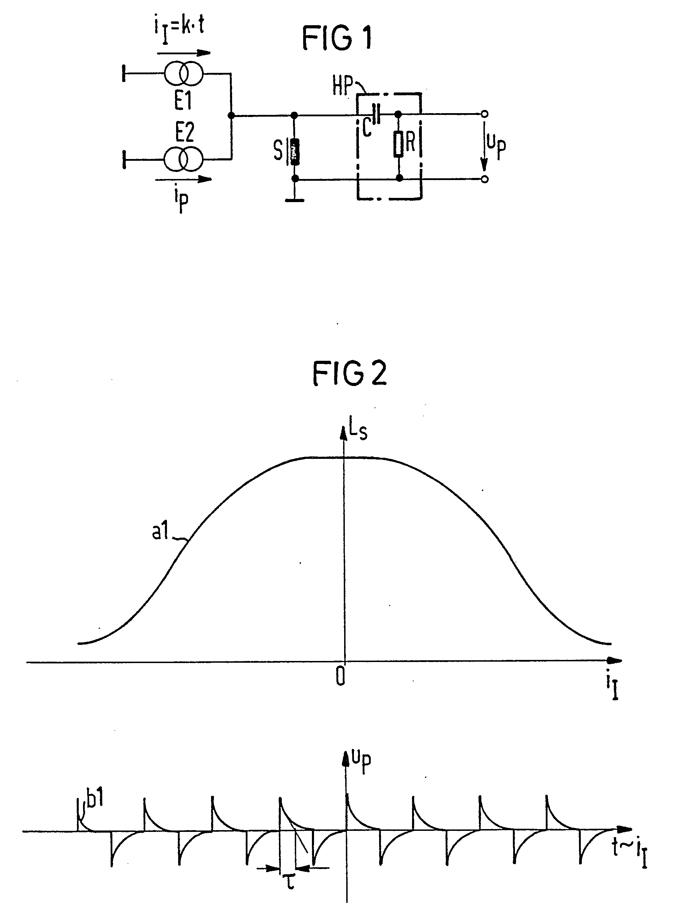

Das Prinzipschaltbild von Fig. 1 zeigt eine Magnetsonde in Form einer Spule S mit der Induktivität $L_S$. An dieser Spule S liegen zwei Stromquellen E1 und E2 an, deren Ströme sich überlagern. Die Stromquelle E1 erzeugt einen Strom $i_l$, der mit der Zeit t nach einer Konstanten k gleichförmig ansteigt, also $i_l = k \cdot t$. Dieser Strom $i_l$ bewirkt, daß die Spule S den gesamten Bereich von der negativen bis zur positiven Sättigung durchläuft. Von der Stromquelle E2 wird dem Strom $i_l$ ein rechteckförmiger Wechselstrom $i_P$ überlagert. Dadurch wird in der Spule S eine Spannungsimpulsfolge $u_P$ erzeugt, die sekundärseitig gemessen wird. Ein Hochpaß HP mit dem Widerstand R und dem Kondensator C eliminiert dabei die Gleichstromkomponente.

Fig. 2 zeigt in der Kurve a1 den Verlauf der Spuleninduktivität $L_S$ in Abhängigkeit vom Vormagnetisierungsstrom $i_l$. Die Spuleninduktivität hat ihr Maximum bei $i_l = 0$ und verringert sich sowohl bei größeren positiven als auch bei größeren negativen Strömen. Darunter zeigt die Kurve b1 den Verlauf der Sekundärspannung $u_P$. Es ist dies eine Impulsfolge entsprechend dem Wechselstrom $i_P$. Die Spannungsimpulse fallen mit unterschiedlicher Zeitkonstante $\tau$ in Abhängigkeit von der Spuleninduktion $L_S$ ab.

Solange kein äußeres Magnetfeld einwirkt, liegt der Impuls mit der größten Zeitkonstante $\tau$ beim

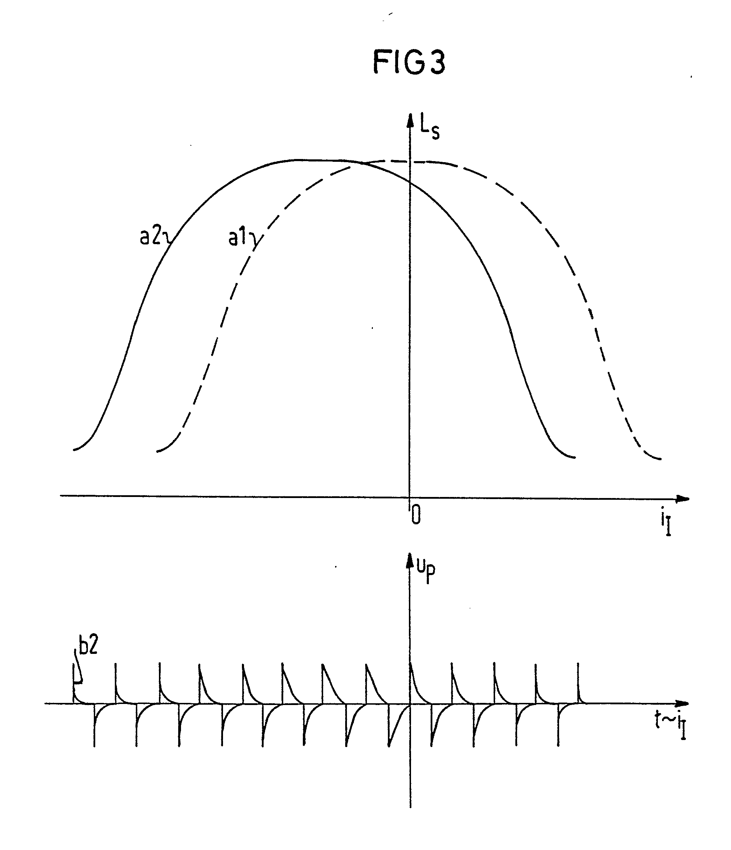

Ursprung, d. h. beim Nullpunkt des Vormagnetisierungsstromes $i_l$. Jedes äußere Magnetfeld addiert oder subtrahiert sich, je nach seiner Richtung, in seiner Wirkung zu dem Vormagnetisierungsstrom $i_l$ und verschiebt damit die Induktivitätskurve relativ zum Ursprung. Fig 3 zeigt eine entsprechend verschobene Induktivitätskurve a2 im Vergleich zur Kurve a1. Entsprechend verschiebt sich auch die Verteilung der Spannungsimpulsfolge $u_P$. Im gezeigten Beispiel ist die Kurve b2 auf die linke Seite gegenüber dem Ursprung verschoben. Auf dieser Seite liegt der Spannungsimpuls mit der größten Zeitkonstante und entsprechend eine größere Anzahl von Spannungsimpulsen mit großer Zeitkonstante $\tau$.

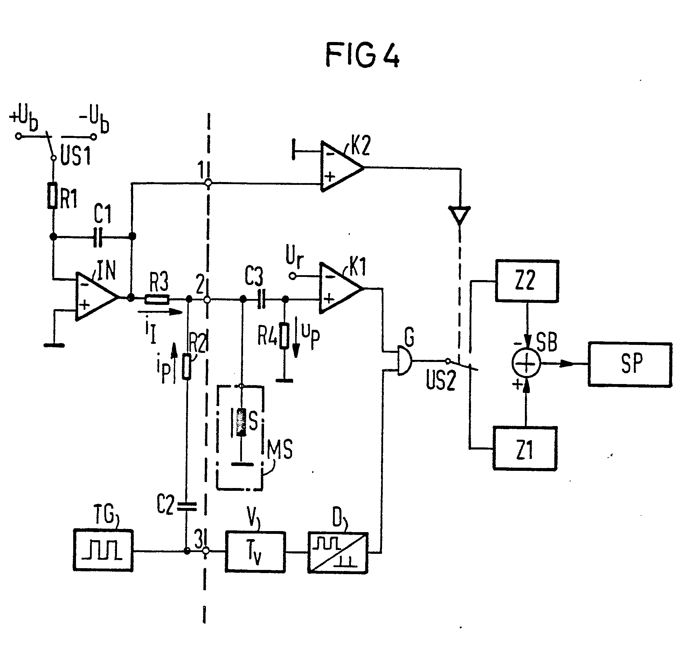

Der beschriebene Effekt wird in einer Schaltungsanordnung gemäß Fig. 4 zur Feldmessung ausgenutzt. Zur Erzeugung des Vormagnetisierungsstromes für die Spule S der Magnetsonde MS sind zwei Gleichspannungen $+ U_b$ und $- U_b$ vorgesehen, an die wahlweise ein Integrator IN anschaltbar ist. Die Integrationsdauer wird durch den Widerstand R1 und den Kondensator C1 bestimmt. Der Ausgang des Integrators IN ist über den Widerstand R3 an die Spule S der Magnetsonde MS geschaltet. Parallel dazu wird der Spule S außerdem ein vom Taktgenerator TG über den Kondensator C2 und den Widerstand R2 eingeprägter Wechselstrom $i_P$ zugeführt. Über einen Hochpaß C3, R4 ist die Spannung $u_P$ auf einen Eingang des Komparators K1 gekoppelt, an dessen invertierendem Eingang eine Referenzspannung $U_r$ liegt.

Dem Komparator K1 ist ein Koinzidenzglied G nachgeschaltet, an dessen zweitem Eingang die Impulse des Taktgenerators TG über ein Verzögerungsglied V und ein Differenzierglied D geschaltet sind. Der Ausgang des Koinzidenzgliedes G ist über einen Umschalter US2 wahlweise an die beiden Zähler Z1 bzw. Z2 anschaltbar. Dieser Umschalter US2 wird von einem Komparator K2 gesteuert, der den Integrationsstrom des Integrators IN auf seine Polarität prüft. Solange also dieser Integrationsstrom $i_l$ negativ ist, ist das Koinzidenzglied G auf den Zähler Z1 geschaltet, bei positivem Integrationsstrom wird die entsprechende Verbindung zum Zähler Z2 hergestellt. Ein den beiden Zählern Z1 und Z2 nachgeschalteter Subtrahierer SB bildet die Differenz der Zählerstände, welche in einen Speicher SP zur weiteren Verarbeitung eingegeben wird.

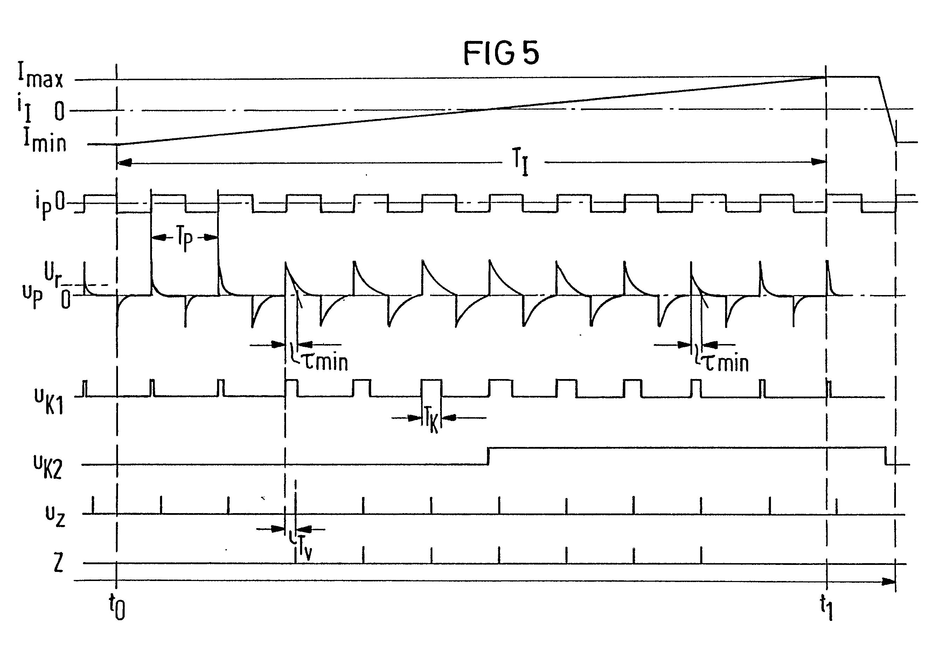

Die Arbeitsweise der Schaltung von Fig. 4 ist am Zeitdiagramm von Fig. 5 abzulesen. Es sei angenommen, daß die Messung zum Zeitpunkt $t = t_0$ gestartet wird. In diesem Moment wird der Umschalter US1 auf die Spannung $- U_b$ geschaltet. Von diesem Zeitpunkt an steigt die Ausgangsspannung $u_l$ und damit der Strom $i_l$ linear an. Die Integrationsdauer ist in Fig. 5 mit $T_l$ bezeichnet.

Der durch den Taktgenerator TG überlagerte Wechselstrom $i_P$ hat eine symmetrische Rechteckimpulsform und verursacht in der Spule mit jeder Impulsflanke einen Spannungssprung, der gemäß einer e-Funktion mit der Zeitkonstanten $\tau$ abklingt. Diese Zeitkonstante ist von der Induktivität $L_S$ der Spule S und vom Widerstand R4 nach der Beziehung

$$\tau = L_S/R4$$

abhängig. Die Impulsspannung $u_P$ ist ebenfalls in Fig. 5 dargestellt.

Die Impulsspannung $u_P$ wird im Komparator K1, an dessen invertierenden Eingang die Referenzspannung $U_r$ anliegt, in die Impulsspannung $u_{K1}$ umgesetzt. Die Breite $T_K$ ist proportional der Zeitkonstante $\tau$ des jeweils zugehörigen Spannungsimpulses $u_P$.

Bei Integrationsströmen $i_l \sim I_{min}$ (negativer Maximalwert) bzw. $i_l \sim I_{max}$ (positiver Maximalwert) ist die Induktivität der Sonde sehr klein. Daraus ergibt sich eine kleine Zeitkonstante $\tau$ und somit ein schmaler Impuls $u_{K1}$. Beim Strom $i_l = 0$ ist die Induktivität am größten, woraus ein Spannungsimpuls $u_{K1}$ mit maximaler Breite $T_K$ resultiert.

Aus der Impulsfolge $i_P$ des Taktgenerators TG wird über das Verzögerungsglied V mit der Verzögerungszeit $T_V$ und das Differenzierglied D eine Zählimpulsfolge $u_Z$ abgeleitet, die gegenüber der positiven Flanke von $i_P$ um die Zeit $T_V$ verzögert ist. Die Signale $u_{K1}$ und $u_Z$ ergeben, über das Koinzidenzglied G verknüpft, die Zählimpulse Z für die beiden Binärzähler Z1 und Z2. Diese Zählimpulse Z entstehen dann, wenn gilt:

$$T_K = k \cdot \tau > T_V,$$

wobei k eine Konstante bildet. Hierdurch wird ein Minimalwert $\tau_{min}$ festgelegt. Alle Impulse mit einer Zeitkonstante $\tau \geq \tau_{min}$ werden gezählt. Wie erwähnt, wird über den Nulldurchgangsdetektor K2 der Umschalter US2 gesteuert. Die Zählimpulse Z gelangen auf den Zähler Z1, solange der Integrationsstrom $i_l$ negativ ist. Beim Nulldurchgang werden sie dann auf den Zähler Z2 umgeleitet.

Wenn kein Magnetfeld auf die Sonde MS einwirkt, sind die beiden Zählerstände von Z1 und Z2 gleich. Ist ein äußeres Magnetfeld vorhanden, so überlagert es sich dem inneren Magnetfeld, das durch den Vormagnetisierungsstrom (Integrationsstrom) hervorgerufen wird, und verschiebt die Induktivitätskurve gegenüber ihrem Ursprung nach rechts oder links. Daraus resultieren unterschiedliche Zählerstände von Z1 und Z2. Die Differenz der Zählerinhalte entspricht der Stärke des äußeren Magnetfeldes. Sie wird durch Differenzbildung im Subtrahierer SB gebildet und steht an deren Ausgang bzw. im Speicher SP zur weiteren Verarbeitung zur Verfügung.

Eine vorteilhafte Variante der Schaltungsanordnung von Fig. 4 ist in Fig. 9 dargestellt. Durch Hinzufügen eines zweiten Komparators K1' ist es möglich, auch die negativen Impulse der Spannung $u_P$ auszuwerten, wodurch sich eine Verdoppelung der Zählimpulse Z ergibt, was eine deutliche Verbesserung der Auflösung bzw. eine Erhöhung der Meßgeschwindigkeit zur Folge hat.

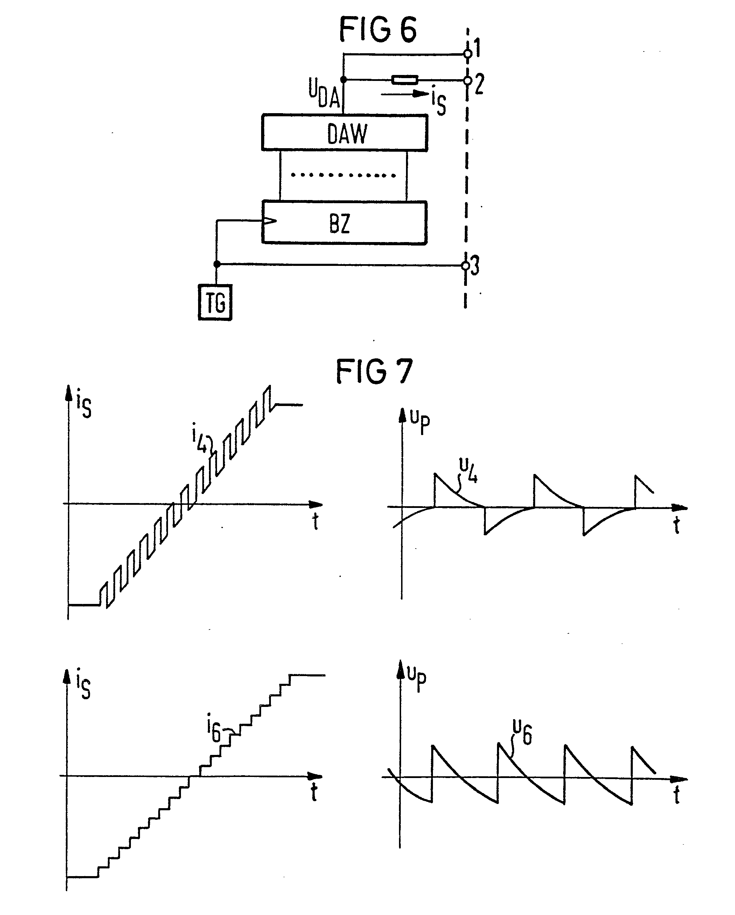

In einer vorteilhaften Variante kann in der Schaltung nach Fig. 4 der Integrator durch einen Digital-Analog-Wandler ersetzt werden, dessen treppenförmige Ausgangsspannung gleichzeitig die Stromimpulse erzeugt. Eine entsprechende Anordnung zeigt Fig. 6. Dem Digital-Analog-Wandler DAW ist ein Binärzähler BZ vorgeschaltet, der durch den Taktgeber TG angesteuert wird. Die Messung startet, wenn der Binärzähler BZ, bei 0 beginnend, im Takt des Taktgenerators TG zu zählen anfängt. Das binäre Ausgangssignal des Zählers BZ wird im Digital-Analog-Wandler DAW in eine entsprechende analoge Ausgangsspannung $u_{DA}$ umgeformt. Diese Ausgangsspannung $u_{DA}$ und damit der Ausgangsstrom der Sonde $i_S$ erhöht sich sprungartig mit jeder Zählerincrementierung. Diese sprungartige Erhöhung ersetzt den bei der Integratorversion notwendigen Pulsstrom $i_P$. Die Anordnung nach Fig. 6 kann an den Anschlußpunkten 1, 2 und 3 in die Schaltung von Fig. 4 eingefügt werden und dort die Integratoranordnung ersetzen.

Ein Vergleich der unterschiedlichen Signalverläufe bei der Anordnung nach Fig. 4 und nach Fig. 6 ist in Fig. 7 dargestellt. Gezeigt ist jeweils der Verlauf des Sondenstroms $i_S$ und der resultierenden Impulsspannung $u_P$ an der Sonde.

Bei der Version mit Integrator nach Fig. 4 entsteht der mäanderförmig ansteigende Strom $i_4$, der die Impulsspannung $u_4$ mit positiven und negativen Impulsflanken erzeugt. Bei der Version mit Digital-Analog-Wandler nach Fig. 6 wird ein treppenförmiger Strom $i_6$ erzeugt, der eine im wesentlichen sägezahnförmige Impulsspannung $u_6$ zur Folge hat.

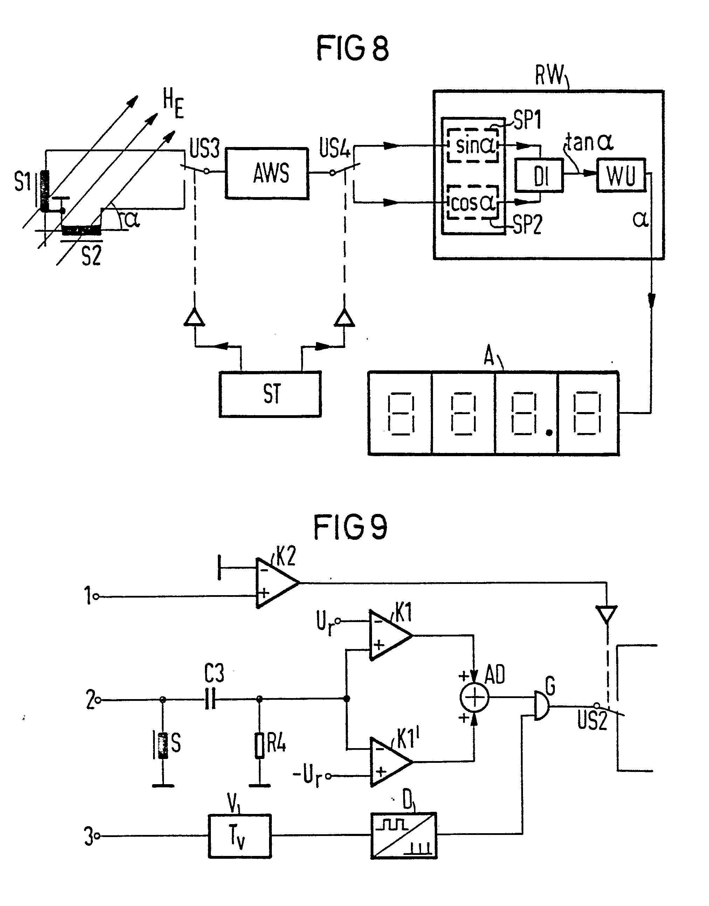

Eine Weiterbildung der Erfindung zeigt Fig. 8, nämlich die Anwendung auf einen elektronischen Kompaß. Er arbeitet mit zwei zueinander senkrecht stehenden Sonden mit den Spulen S1 und S2 und kann damit die Winkelrichtung $\alpha$ gegenüber dem Erdmagnetfeld $H_E$ ermitteln.

Die Spulen S1 und S2 werden über die Multiplexsteuerung ST mit dem Umschalter US3 abwechselnd an die Auswerteschaltung AWS angeschaltet. Diese Auswerteschaltung AWS entspricht beispielsweise der Schaltung nach Fig. 4. Gleichzeitig wird der Umschalter US4 mit betätigt, so daß das Meßergebnis mit der Spule S1 in den Speicher SP1 und das Meßergebnis mit der Spule S2 in den Speicher SP2 gegeben wird. Diese Speicher SP1 und SP2 sind einem Rechenwerk RW zugeordnet, welches den Speichern nachgeschaltet einen Dividierer DI und einen Winkelumsetzer WU besitzt.

Die Sonde mit der Spule S1 mißt die Y-Komponente des Erdmagnetfeldes und die Sonde mit der Spule S2 mißt die X-Komponente. Dann gilt

$$H_Y = H_{S1} = H_E \cdot \sin\alpha$$
$$H_X = H_{S2} = H_E \cdot \cos\alpha.$$

Die beiden dem Sinus und dem Cosinus des Winkels $\alpha$ proportionalen Meßwerte werden in den Speichern SP1 und SP2 zwischengespeichert und gelangen von dort auf den Dividierer DI, an dessen Ausgang ein dem Tangens des Winkels proportionaler Wert steht. Im Winkelfunktionsumsetzer WU erfolgt eine Arcus-Tangens-Bildung, so daß am Ausgang des Rechenwerkes RW der Winkel $\alpha$ als binärer Zahlenwert ansteht. Er kann in beliebiger Form angezeigt werden, beispielsweise mit einer Siebensegmentanzeige A.

**Patentansprüche**

1. Verfahren zur Messung eines Magnetfeldes, insbesondere des Erdmagnetfeldes, mittels einer Magnetsonde in Form einer Spule (S) mit Eisenkern, wobei an die Spule (S) ein veränderlicher Erregerstrom von einer derartigen Größe angelegt wird, daß der Eisenkern jeweils den positiven und den negativen Sättigungswert erreicht, und wobei durch Messung der induzierten Spannung an der Spule (S) die Änderung des Induktivitätsverlaufes gegenüber dem Verlauf des Erregerstroms ermittelt und daraus die Stärke des äußeren Magnetfeldes in Richtung der Sondenachse gewonnen wird, dadurch gekennzeichnet, daß an die Spule (S) ein schrittweise sprungartig von einem negativen Maximalwert ($I_{min}$) bis zu einem positiven Maximalwert ($I_{max}$) ansteigender Erregerstrom ($i_S$) angelegt und die an der Spule (S) dadurch induzierten, entsprechend der momentanen Spuleninduktivität ($L_S$) mit unterschiedlicher Zeitkonstante ($\tau$) abklingenden Spannungsimpulse ($u_P$) gemessen werden, daß aus allen Spannungsimpulsen ($u_P$), deren Zeitkonstante ($\tau$) einen vorgegebenen Wert ($\tau_{min}$) überschreitet, Zählimpulse (Z) gebildet und die jeweilige Anzahl der Zählimpulse bei jeweils negativem und positivem Erregerstrom miteinander verglichen sowie aus dem Differenzbetrag die Stärke des äußeren Magnetfeldes ermittelt wird.

2. Verfahren nach Anspruch 1, dadurch gekennzeichnet, daß der Erregerstrom ($i_S$) durch Überlagerung eines linear ansteigenden Stromes ($i_I$) mit einem rechteckförmigen Wechselstrom ($i_P$) gebildet wird.

3. Verfahren nach Anspruch 1, dadurch gekennzeichnet, daß der Erregerstrom ($i_6$) mittels einer treppenförmig ansteigenden Spannung erzeugt wird.

4. Verfahren nach einem der Ansprüche 1 bis 3, dadurch gekennzeichnet, daß die gemessenen Spannungsimpulse ($u_P$) in Rechteckimpulse ($u_{K1}$) mit einer der jeweiligen Zeitkonstante ($\tau$) proportionalen Impulsbreite ($T_K$) umgeformt werden und jeweils mit einem gegenüber den ansteigenden Flanken des Erregerstroms um eine vorgegebene Zeit verzögerten Zählimpuls ($u_Z$) verglichen werden, wobei nur bei gleichzeitigem Vorhandensein beider Impulsarten der jeweilige Zählimpuls ($u_Z$) weitergeschaltet wird.

5. Verfahren nach einem der Ansprüche 1 bis 4, dadurch gekennzeichnet, daß an zwei zueinander senkrecht stehenden Magnetsonden (S1, S2) abwechselnd die Stärke des jeweiligen Magnetfeldes in Richtung der Spulenachse gemessen wird und daß aus den beiden Meßwerten der Winkel ($\alpha$) der Sondenanordnung gegenüber den Feldlinien des äußeren Feldes ($H_E$) bestimmt wird.

6. Schaltungsanordnung zur Durchführung des Verfahrens nach einem der Ansprüche 1 bis 5, dadurch gekennzeichnet, daß der an eine über einen Taktgeber (TG) veränderliche Stromquelle (IN) angeschalteten Spule (S) eine die Spulenspannung ($u_P$) mit einer Referenzspannung ($U_r$) vergleichende Spannungsmeßeinrichtung (K1) nachgeschaltet ist, deren Ausgang an den ersten Eingang eines Koinzidenzgliedes (G) geschaltet ist, daß die Ausgangssignale des Taktgebers (TG) außerdem über ein Verzögerungsglied (V) dem zweiten Eingang des Koinzidenzgliedes (G) zugeführt sind und daß dem Koinzidenzglied (G) eine differenzbildende Impulszähleinrichtung (Z1, Z2, SB) nachgeschaltet ist, welche entsprechend der Polarität des Erregerstromes umschaltbar ist.

7. Schaltungsanordnung nach Anspruch 6, dadurch gekennzeichnet, daß zwischen die Spule (S) und die Spannungsmeßeinrichtung (K1) ein Hochpaß (C3, R4) geschaltet ist.

8. Schaltungsanordnung nach Anspruch 6 oder 7, dadurch gekennzeichnet, daß als Spannungsmeßeinrichtung ein Komparator (K1) vorgesehen ist, an dessen einem Eingang ein Anschluß der Spule (S) und an dessen zweiten Eingang eine Referenzspannung ($U_r$) anliegt.

9. Schaltungsanordnung nach Anspruch 6 oder 7, dadurch gekennzeichnet, daß als Spannungsmeßeinrichtung zwei Komparatoren (K1 und K1') vorgesehen sind, bei denen jeweils ein erster Eingang mit einem Anschluß der Spule (S) verbunden ist und wobei am zweiten Eingang des ersten Komparators (K1) eine positive Referenzspannung ($U_r$) und am zweiten Eingang des zweiten Komparators (K1') eine negative Referenzspannung ($- U_r$) anliegt.

10. Schaltungsanordnung nach einem der Ansprüche 6 bis 9, dadurch gekennzeichnet, daß als Stromquelle eine Gleichspannungsquelle ($- U_b$, $+ U_b$) mit nachgeschaltetem Integrator (IN) verwendet ist, dessen linear ansteigendem Ausgangsstrom ($i_l$) ein vom Taktgenerator (TG) erzeugter Wechselstrom ($i_P$) überlagert ist.

11. Schaltungsanordnung nach einem der Ansprüche 6 bis 10, dadurch gekennzeichnet, daß die Zähleinrichtung (Z1, Z2) zwei alternativ an das Koinzidenzglied (G) anschaltbare Zähler (Z1, Z2) enthält, deren Ausgänge einem Subtrahierer (SB) zugeführt sind.

12. Schaltungsanordnung nach einem der Ansprüche 6 bis 9 oder 10, dadurch gekennzeichnet, daß die Stromquelle durch einen Digital-Analog-Wandler (DAW) gebildet ist, an deren Eingang ein vom Taktgeber (TG) beaufschlagter Binärzähler (BZ) geschaltet ist.

13. Schaltungsanordnung nach einem der Ansprüche 6 bis 12, dadurch gekennzeichnet, daß zwei mit ihren Achsen aufeinander senkrecht stehende Spulen (S1, S2) vorgesehen sind, welche über eine Umschalteinrichtung (US3) abwechselnd an die Erregerspannung und die Spannungsmeßeinrichtung (AWS) anschaltbar sind, daß ferner der Ausgang der Spannungsmeßeinrichtung entsprechend zwischen zwei den Spulen (S1, S2) zugeordneten Speichern (SP1, SP2) umschaltbar ist, die in ein Rechenwerk (RW) zur Ermittlung des Winkels ($\alpha$) einer Sonde gegenüber dem äußeren Magnetfeld (H) einbezogen sind.

14. Schaltungsanordnung nach Anspruch 13, dadurch gekennzeichnet, daß das Rechenwerk (RW) einen Dividierer (DI) sowie einen Winkelfunktionsumsetzer (WU) enthält.

15. Schaltungsanordnung nach Anspruch 13 oder 14, dadurch gekennzeichnet, daß dem Rechenwerk (RW) eine Anzeigeeinrichtung (A) nachgeschaltet ist.

## Claims

1. A method of measuring a magnetic field, in particular the terrestrial magnetic field, by means of a magnetic probe in the form of a coil (S) having an iron core, where the coil (S) is subjected to a variable excitation current whose value is such that the iron core reaches its positive and negative saturation value, and where the change in the inductance curve relative to the curve of the excitation current is determined by measuring the induced voltage across the coil (S), from which is obtained the strength of the external magnetic field in the direction of the probe axis, characterised in that the coil (S) is supplied with an excitation current ($i_S$) which rises from a negative maximum value ($I_{min}$) to a positive maximum value ($I_{max}$) and the voltage pulses ($u_P$) thereby induced across the coil (S) and decay in accordance with the instantaneous coil inductance ($L_S$) with a different time constant ($\tau$) are measured, that from all the voltage pulses ($u_P$) whose time constant ($\tau$) exceeds a given value ($\tau_{min}$) counting pulses (Z) are formed, and the number of counting pulses resulting form a negative and positive excitation current, in each case, are compared with one another and the magnitude of the external magnetic field is determined from the amount of the difference.

2. A method as claimed in Claim 1, characterised in that the excitation current ($i_S$) is formed by the superimposition of a linearly rising current ($i_l$) with a rectangular alternating current ($i_P$).

3. A method as claimed in Claim 1, characterised in that the excitation current ($i_S$) is produced by means of a voltage which rises in stepped fashion.

4. A method as claimed in one of the preceding Claims 1 to 3, characterised in that the measured voltage pulses ($u_P$) are converted into rectangular pulses ($u_{K1}$) having a pulse width ($T_K$) which is proportional to the particular time constant ($\tau$), and are in each case compared with a counting pulse ($u_Z$) delayed by a given length of time relative to the rising flanks of the excitation current, where the counting pulse in question

($u_Z$) is stepped on only when the two types of pulse are simultaneously present.

5. A method as claimed in one of the Claims 1 to 4, characterised in that the magnitude of the particular magnetic field in the direction of the coil axis is measured in alternation across two magnetic probes (S1, S2) arranged at right angles to one another, and that the angle ($\alpha$) of the probe arrangement relative to the field lines of the external field ($H_E$) is determined from the two measured values.

6. A circuit arrangement for the implementation of the method claimed in one of the Claims 1 to 5, characterised in that the coil (S) is connected to a current source (IN), which is variable via a clock pulse generator (TG), followed by a voltage measuring device (K1) which compares the coil voltage ($u_P$) with a reference voltage ($U_r$) and whose output is connected to the first input of a coincidence gate (G), that the output signals of the clock pulse generator (TG) are also fed via a delay element (V) to the second input of the coincidence gate (G), and that the coincidence gate (G) is followed by a difference-forming pulse counting device (Z1, Z2, SB) which can be switched over in accordance with the polarity of the excitation current.

7. A circuit arrangement as claimed in Claim 6, characterised in that a high-pass filter (C3, R4) is connected between the coil (S) and the voltage measuring device (K1).

8. A circuit arrangement as claimed in Claim 6 or 7, characterised in that the voltage measuring device consists of a comparator (K1) whose first input is connected to a terminal of the coil (S) and whose second input is connected to a reference voltage ($U_r$).

9. A circuit arrangement as claimed in Claim 6 or 7, characterised in that the voltage measuring device consists of two comparators (K1, K1') of which a first input is in each case connected to a terminal of the coil (S), and where the second input of the first comparator (K1) is connected to a positive reference voltage ($U_r$) and the second input of the second comparator (K1') is connected to a negative reference voltage ($- U_r$).

10. A circuit arrangement as claimed in one of the Claims 6 to 9, characterised in that the current source consists of a d. c. voltage source ($- U_b$, $+ U_b$) followed by an integrator (IN) upon whose linearly rising output current ($i_l$) there is superimposed an alternating current ($i_P$) produced by the clock pulse generator (TG).

11. A circuit arrangement as claimed in one of the Claims 6 to 10, characterised in that the counting device (Z1, Z2) contains two counters (Z1, Z2) alternately connected to the coincidence gate (G), whose outputs lead to a subtractor (SB).

12. A circuit arrangement as claimed in one of the Claims 6 to 9 or 10, characterised in that the current source is formed by a digital-to-analogue converter (DAW) whose input is connected to a binary counter (BZ) which is acted upon by the clock pulse generator (TG).

13. A circuit arrangement as claimed in one of the Claims 6 to 12, characterised in that two coils (S1, S2) are provided whose axes are at right angles to one another and which can be connected via a switch-over device (US3) alternately to the excitation voltage and to the voltage measuring device (AWS), that moreover the output of the voltage measuring device can be switched over accordingly between two stores (SP1, SP2) which are assigned to the coil (S1, S2) and form part of a calculating unit (RW) which serves to determine the angle ($\alpha$) of a probe relative to the external magnetic field (H).

14. A circuit arrangement as claimed in Claim 13, characterised in that the calculating unit (RW) contains a divider (DI) and an angle function converter (WU).

15. A circuit arrangement as claimed in Claim 13 or 14, characterised in that the calculating unit (RW) is followed by a display device (A).

**Revendications**

1. Procédé pour mesurer un champ magnétique, en particulier le champ magnétique terrestre, à l'aide d'une sonde magnétique sous la forme d'une bobine (S) à noyau de fer, du type dans lequel la bobine (S) est parcourue par un courant d'excitation variable d'une intensité telle que le noyau de fer atteint respectivement la valeur de saturation positive et négative, et dans lequel, par la mesure de la tension induite dans la bobine (S), on détermine la modification de l'allure de l'inductance par rapport à l'allure du courant d'excitation et on en déduit l'intensité du flux magnétique extérieur dans la direction de l'axe de la sonde, caractérisé par le fait que l'on fait passer pas-à-pas par la bobine (S) un courant d'excitation ($i_S$) qui croît par à-coups d'une valeur maximale négative ($I_{min}$) jusqu'à une valeur maximale positive ($I_{max}$) et que l'on mesure les impulsions de tension ($u_P$), qui, de ce fait, sont induites au niveau de la bobine, et qui décroissent, en fonction de l'inductance momentanée ($L_S$) de la bobine, avec une constante de temps ($\tau$) différente, qu'à partir de toutes les impulsions de tension ($u_P$) dont la constante de temps ($\tau$) dépasse une valeur prédéterminée ($\tau_{min}$), on forme des impulsions de comptage (Z) et que les nombres des impulsions de comptage respectivement pour un courant d'excitation positif et négatif, sont comparés entre eux, alors qu'à partir de la valeur de la différence on détermine l'intensité du champ magnétique extérieur.

2. Procédé selon la revendication 1, caractérisé par le fait que le courant d'excitation ($i_S$) est formé par la superposition d'un courant ($i_l$) croissant de façon linéaire avec un courant alternatif ($i_P$) de forme rectangulaire.

3. Procédé selon la revendication 1, caractérisé par le fait que le courant d'excitation ($i_S$) est produit à l'aide d'une tension passante en forme de paliers.

4. Procédé selon l'une des revendications 1 à 3, caractérisé par le fait que les impulsions de

tension (u$_P$) qui sont mesurées, sont transformées en impulsions rectangulaires (u$_{K1}$) ayant une largeur d'impulsion qui est proportionnelle avec la constante de temps respective (τ) et sont comparées respectivement avec une impulsion de comptage (u$_Z$) retardée d'une durée prédéterminée par rapport aux flancs croissants du courant d'excitation, l'impulsion de comptage concernée (u$_Z$) n'étant transmise que lors de la présence simultanée des deux genres d'impulsions.

5. Procédé selon l'une des revendications 1 à 4 caractérisé par le fait qu'au niveau de deux sondes magnétiques (S1, S2) qui sont disposées perpendiculairement l'une par rapport à l'autre, on mesure alternativement l'intensité du champ magnétique correspondant dans la direction de l'axe de la bobine, et qu'à partir des deux valeurs de mesure on détermine l'angle (α) de la disposition à sondes par rapport aux lignes de champ du champ extérieur (H$_E$)

6. Montage pour la mise en œuvre du procédé selon l'une des revendications 1 à 5, caractérisé par le fait qu'en aval de la bobine (S) qui est reliée à une source de courant variable (IN), par l'intermédiaire d'un générateur de cadence (TG), est relié un dispositif de mesure de la tension (K1) qui compare la tension de la bobine (u$_P$) avec une tension de référence (U$_r$) et dont la sortie est reliée à la première entrée d'un circuit de coïncidence (G), que les signaux de sortie du générateur de cadence (TG) sont en outre appliqués, par l'intermédiaire d'un élément à retard (V), à la seconde entrée du circuit de coïncidence (G), et qu'en aval du circuit de coïncidence (G) est monté un dispositif de comptage des impulsions (Z1, Z2, SB) formant la différence, lequel dispositif de comptage des impulsions est susceptible d'être commuté en fonction de la polarité du courant d'excitation.

7. Montage selon la revendication 6, caractérisé par le fait qu'entre la bobine (S) et le dispositif de mesure de la tension (K1) est prévu un passe-haut (C3, R4).

8. Montage selon la revendication 6 ou 7, caractérisé par le fait qu'il est prévu, en tant que dispositif de mesure de la tension, un comparateur à l'une des entrées duquel se situe une borne de liaison de la bobine (S) et à la seconde entrée duquel est appliquée une tension de référence (U$_r$).

9. Montage selon la revendication 6 ou 7, caractérisé par le fait que l'on utilise comme dispositif de mesure de la tension, deux comparateurs (K1 et K1') dans lesquels respectivement une première entrée est reliée à une borne de la bobine (S) alors qu'à la seconde entrée du premier comparateur (K1) est appliquée une tension de référence positive (U$_r$) et à la seconde entrée du second comparateur (K1') est appliquée une source de référence négative (− U$_r$).

10. Montage selon l'une des revendications 6 à 9, caractérisé par le fait que l'on utilise comme source de courant une source de tension continue (− U$_b$, + U$_b$) avec un intégrateur (IN) monté en aval, intégrateur au courant de sortie (i$_l$) qui croît linéairement auquel est superposé un courant alternatif (i$_P$) produit par le générateur de cadence (TG).

11. Montage selon l'une des revendications 6 à 10, caractérisé par le fait que le dispositif de comptage (Z1, Z2) comporte deux compteurs (Z1, Z2) susceptibles d'être reliés alternativement au circuit de coïncidence (G), compteurs dont les sorties sont appliquées à un soustracteur (SB).

12. Montage selon l'une des revendications 6 à 9 ou 10, caractérisé par le fait que la source de courant est formée par un convertisseur numérique-analogique (DAW) à l'entrée duquel est relié un compteur binaire (BZ) qui est chargé par le générateur de cadence (TG).

13. Montage selon l'une des revendications 6 à 12, caractérisé par le fait qu'il est prévu deux bobines (S1, S2) dont les axes sont perpendiculaires entre eux, bobines qui sont susceptibles, par l'intermédiaire d'un dispositif de commutation (US3), d'être reliées alternativement à la tension d'excitation et au dispositif de mesure de la tension (AWS), qu'en outre la sortie du dispositif de mesure de la tension est susceptible d'être commutée de façon correspondante entre deux mémoires (SP1, SP2) associées aux bobines (S1, S2), lesquelles mémoires qui sont incorporées dans un organe de calcul (RW) en vue de déterminer l'angle (α) d'une sonde par rapport au champ magnétique extérieur (H).

14. Montage suivant la revendication 13, caractérisé par le fait que l'organe de calcul (RW) comporte un diviseur (DI) ainsi qu'un convertisseur de fonction angulaire (WU).

15. Montage selon la revendication 13 ou 14, caractérisé par le fait qu'en aval de l'organe de calcul (RW) est prévu un dispositif d'affichage (A.).

FIG 1

FIG 2

## FIG 3

# FIG 4

FIG 5

0 065 762

# FIG 6

# FIG 7

# FIG 8

# FIG 9